# EUROPEAN PATENT SPECIFICATION

(11) **EP 4 145 146 B1**
(45) Date of publication and mention of the grant of the patent: **18.02.2026**
(21) Application number: 22183597.8
(22) Date of filing: 07.07.2022
(51) Int. Cl.: G01R 29/10

(54) **MEASUREMENT METHOD AND MEASUREMENT SYSTEM**
MESSVERFAHREN UND MESSSYSTEM
SYSTÈME ET PROCÉDÉ DE MESURE

(43) Date of publication of application: 08.03.2023
(73) Proprietor: Rohde & Schwarz GmbH & Co. KG, 81671 München (DE)
(72) Inventor: Derat, Benoit, 81671 München (DE); Tankielun, Adam, 81671 München (DE)
(74) Representative: Novagraaf Group

(56) References cited:
- WO-A1-2020/074772
- US-A1- 2011 084 887
- US-A1- 2018 102 859
- US-A1- 2018 212 695
- US-A1- 2020 213 883
- BARTKO HENDRIK ET AL: "New Measurements Concept of Electrically Large Active Antenna Systems in Compact Test Chambers", 2019 8TH ASIA-PACIFIC CONFERENCE ON ANTENNAS AND PROPAGATION (APCAP), IEEE, 4 August 2019 (2019-08-04), pages 599 - 600, XP033938118, DOI: 10.1109/APCAP47827.2019.9472079

## Description

The invention generally relates to a measurement method of performing over-the-air (OTA) measurements on a device under test. The invention further relates to a measurement system for OTA measurements on a device under test.

Electronic devices that are configured for wireless communication usually are tested during or after production in order to ensure the correct functionality of the electronic device.

Therein, the electronic devices may have fully integrated radio frequency (RF) antennas with no accessible RF port and/or RF antennas with accessible RF port.

Tests of the relevant system parameters of such an electronic device are typically done over-the-air (OTA) in a test chamber and require far-field conditions.

For example, far-field conditions are obtained when the test environment allows to create a quiet zone encompassing the electronic device to be tested, wherein the field generated by a measurement antenna array in this region closely resembles a plane wave.

In general, the quiet zone generated by the measurement antenna array needs to be at least as large as the antenna(s) of the electronic device to be tested in order to obtain correct measurements.

Accordingly, the size of the test chamber has to be larger in order to allow for testing electronic devices having larger antennas, which is generally undesirable.

WO 2020/074772 A1 discloses a measurement antenna array that comprises a plurality of antenna elements that are arranged in concentric rings. The amplitude and phase weightings of the individual rings are adjustable by a processor. The measurement antenna array establishes a plane wave converter that allows for performing far-field measurements closer to a device under test than usual.

Thus, the object of the present invention is a to provide a measurement method of performing OTA measurements as well as a measurement system for performing OTA measurements that have reduced spatial requirements.

According to the invention, the problem is solved by a measurement method of performing over-the-air (OTA) measurements on a device under test. The measurement method comprises the steps of
a) providing a measurement antenna array, wherein the measurement antenna array comprises a plurality of measurement antennas having an adjustable signal weight to a measurement signal processed by the measurement antenna array, respectively;
b) providing a device under test, wherein the device under test comprises at least one antenna to be tested, wherein the device under test is placed with respect to the measurement antenna array such that the measurement antenna array is located in a near-field region of the device under test;
c) selecting, by means of a control circuit, a measurement antenna subset, wherein the measurement antenna subset comprises at least one of the plurality of measurement antennas;
d) receiving, by means of the selected measurement antenna subset, electromagnetic waves generated by the at least one antenna to be tested, thereby obtaining the measurement signal that is forwarded to a processing circuit;
e) receiving, by means of the processing circuit, a reference signal from a reference signal source; and
f) determining, by means of the processing circuit, at least one measurement parameter associated with the at least one antenna to be tested based on the measurement signal and based on the reference signal.

Therein and in the following, the term "measurement antenna subset" is understood to denote one or more measurement antennas, i.e. a single measurement antenna or a plurality of measurement antennas.

Further, the term "adjustable signal weight to a measurement signal processed by the measurement antenna array" is understood to denote that a contribution of each of the plurality of measurement antennas to the overall measurement signal is weighted with a suitable complex-valued weighting factor.

The individual weighted measurement signals are summed in order to obtain the overall measurement signal of the measurement antenna array.

In other words, the amplitudes and/or phases of the individual measurement signals of the individual measurement antennas are modified in a predetermined manner by multiplying the individual measurement signals with respective complex numbers, such that the overall receiver and/or transmitter characteristic of the measurement antenna array is modified in a predetermined manner.

Thus, the measurement antenna array may also be called a "phased array".

Within the context of the present disclosure, the term "adjustable signal weight to a measurement signal processed by the measurement antenna array" is further understood to comprise the meaning that individual measurement antennas or subgroups of measurement antennas may be switched off, which is equivalent to a weighting factor of 0.

Further, the term "circuit" is understood to describe a module with suitable hardware, suitable software, or a combination of hardware and software, which is configured to have a certain functionality. Thus, the term "circuit" may be replaced by the term "module".

The hardware may, inter alia, comprise a CPU, a GPU, an FPGA, an ASIC, or other types of electronic circuitry.

The measurement method according to the present invention is based on the idea to use a subset of antennas of the phased array, namely the selected measurement antenna subset, as a measurement probe for conducting near-field measurements on the device under test at least in certain circumstances.

In fact, the measurement antenna array may have two different operational modes.

In a first operational mode, the complete measurement antenna array may be configured to generate a quiet zone, i.e. a region having predefined electromagnetic properties, thereby simulating far-field conditions in a region associated with the device under test.

As long as the device under test or rather the at least one antenna to be tested is smaller than the quiet zone generated by the measurement antenna array, direct OTA measurements with simulated far-field conditions can be performed by means of the measurement antenna array, as is well-known in the state-of-the-art.

However, if the device under test or rather the at least one antenna to be tested is larger than the quiet zone that is obtainable by means of the measurement antenna array, near-field measurements are performed by means of the selected measurement antenna subset in a second operational mode of the measurement antenna array.

In the second operational mode, the selected measurement antenna subset serves as a measurement probe for conducting the near-field measurements.

Therein, the reference signal provides a phase reference for determining the at least one measurement parameter, which is necessary for performing near-field measurements.

If the selected measurement antenna subset comprises a plurality of measurement antennas, the signal weights of the plurality of measurement antennas may be optimized such that a desired receiver and/or transmitter characteristic of the measurement antenna subset is obtained for performing the near-field measurements.

It has turned out that the spatial requirements on a measurement system for performing the method described above, particularly the requirements on the size of an anechoic chamber housing the measurement antenna array and the device under test, are significantly reduced compared to other measurement systems known in the state-of-the-art.

For example, if the largest antenna to be tested of the device under test has a length of about 2 m, conventional measurement methods would typically require an anechoic chamber with a size of 7 m x 4 m x 4m. However, with the measurement method according to the present invention, the spatial requirements can be reduced to 5.8 m x 4 m x 4m.

The at least one measurement parameter may be a (total) radiated power, an angular distribution of the radiated power, an error vector magnitude (EVM), an angular distribution of the EVM, an adjacent channel leakage power ratio, an angular distribution of the adjacent channel leakage power ratio, or any other measurement parameter of interest that is characterizing the performance of the device under test.

It is noted that the measurement method according to the present invention is suitable for both devices under test having an accessible RF port and for devices under test not having an accessible RF port, albeit with small adaptations to the measurement setup, as will be described in more detail below.

Further, the measurement method according to the present invention is suitable for both devices under test generating a continuous wave (CW) signal and for devices under test generating a digitally modulated signal.

According to an aspect of the present invention, the measurement antenna array is a plane wave converter. In the context of the present disclosure, the term plane wave converter is used both for a receiver mode of the measurement antenna array, it is i.e. for a plane wave receiver, and for a transmitter mode of the measurement antenna array, i.e. for a plane wave synthesizer.

Accordingly, the measurement antenna array may be configured to generate a quiet zone in a measurement region in which the device under test is placed, such that far-field conditions are simulated.

According to another aspect of the present invention, the processing circuit is integrated into a phase-coherent receiver, wherein the phase-coherent receiver is connected to the measurement antenna array. In general, the phase-coherent receiver is configured to process at least two different signals, namely the measurement signal received from the measurement antenna array and the reference signal received from the reference signal source.

In fact, the phase-coherent receiver may be any suitable measurement instrument.

In an embodiment of the present invention, the reference signal source is integrated into the phase-coherent receiver, wherein the phase-coherent receiver is connected to the device under test. Thus, the phase-coherent receiver or rather the reference signal source integrated into the phase-coherent receiver provides the reference signal that is necessary for determining the at least one measurement parameter based on the near-field measurements conducted by means of the selected measurement antenna subset.

For example, the reference signal source may be a local oscillator that is integrated into the phase-coherent receiver.

The phase-coherent receiver may be connected to an RF port of the at least one antenna to be tested. Accordingly, the phase-coherent receiver may generate an RF signal and may forward the RF signal to the at least one antenna to be tested, such that the at least one antenna to be tested generates the electromagnetic waves based on the RF signal.

In a further embodiment of the present invention, the phase-coherent receiver is a vector signal analyzer. However, it is to be understood that the phase-coherent receiver may be any other suitable measurement instrument or suitable combination of measurement instruments.

Another aspect of the present invention provides that the phase-coherent receiver comprises a signal generator, wherein the signal generator is connected with the device under test, and wherein the signal generator controls the at least one antenna to be tested to generate the electromagnetic waves. Particularly, the signal generator may be a vector signal generator.

The signal generator may be connected to an RF port of the at least one antenna to be tested. Accordingly, the signal generator may generate an RF signal and may forward the RF signal to the at least one antenna to be tested, such that the at least one antenna to be tested generates the electromagnetic waves based on the RF signal received from the signal generator.

According to an aspect of the present invention, the reference signal source is a reference antenna, wherein the reference antenna receives electromagnetic waves generated by the at least one antenna to be tested, thereby generating the reference signal. Thus, the reference antenna provides the reference signal that is necessary for determining the at least one measurement parameter based on the near-field measurements conducted by means of the selected measurement antenna subset.

Particularly, the reference antenna is mounted at a predefined immutable relative position to the device under test. Thus, measurements of the electromagnetic waves generated the at least one antenna to be tested by means of the reference antenna provide a reliable phase reference for determining the at least one measurement parameter.

Therein and in the following, the term "relative position" is understood to denote a relative location, i.e. a distance between the reference antenna and the device under test, and/or a relative orientation between the reference antenna and the device under test.

According to another aspect of the present invention, the device under test is mounted on a DUT positioner, wherein a position of the device under test is adaptable by means of the DUT positioner. In general, the DUT positioner is configured to hold the device under test in a predefined position, for example during a measurement, and to adapt the position of the device under test, for example between different measurements.

The DUT positioner may be configured to rotate the device under test around a roll axis of the device under test and/or around an azimuth axis of the device under test. Alternatively or additionally, the DUT positioner may be configured to adapt a height of the device under test.

However, any other suitable DUT positioner may be used, i.e. any suitable combination of linear positioner and/or rotational positioner.

The reference antenna described above may be mounted on the DUT positioner such that the DUT positioner simultaneously adapts the position of the device under test and of the reference antenna, wherein the relative position between the device under test and the reference antenna is unchanged.

In a further embodiment of the present invention, several measurement signals are obtained consecutively at different positions of the device under test, wherein at least one respective measurement parameter is determined based on the measurement signals, respectively. In other words, the position of the device under test may be adapted and the at least one respective measurement parameter may be determined for each position of the device under test, particularly wherein the measurement antenna array may remain stationary.

Accordingly, a predefined sampling grid of several measurement points on a surface around the device under test is obtained, as the at least one measurement parameter is determined for several different positions of the device under test. For example, a closed sampling grid on a surface surrounding the device under test may be obtained.

Accordingly, an angular distribution of the at least one measurement parameter may be determined, for example an angular distribution of the radiated power, an angular distribution of the EVM, an angular distribution of the adjacent channel leakage power ratio, or an angular distribution of any other measurement parameter of interest.

Several measurement signals may be obtained consecutively by means of different selected subsets of measurement antennas, wherein at least one respective measurement parameter is determined based on the measurement signals, respectively. In other words, several measurements are performed by means of different subsets of measurement antennas, namely by electronically switching between the different measurement antenna subsets. This technique may also be called "electronically switched near-field scanning".

As different measurement antenna subsets have a different relative position to the device under test, a predefined sampling grid of several measurement points on a surface around the device under test is obtained.

The time necessary for determining the at least one measurement parameter over the predefined sampling grid can be reduced significantly by employing the electronically switched near-filed scanning described above, as the electronic switching between different measurement antenna subsets can be performed in a particularly fast manner.

In fact, several measurement signals may be obtained consecutively at different positions of the device under test and/or by means of different selected subsets of measurement antennas, i.e. the two aspects described above can be combined arbitrarily.

For example, several measurement signals may be obtained consecutively at different positions, wherein several measurement signals may be obtained for each position of the device under test by means of different selected subsets of measurement antennas. Thus, a predefined (closed) sampling grid on a surface surrounding the device under test may be obtained in a particularly fast manner.

In an embodiment of the present invention, the measurement antenna subset is selected based on a current position of the device under test. Accordingly, a suitable measurement antenna subset or several different suitable measurement antenna subsets may be selected for each position of the device under test, namely such that a desired sampling grid is obtained in a particularly fast manner.

According to a further aspect of the present invention, the measurement antenna array remains stationary. More precisely, the measurement antenna array may remain at a predefined position (i.e. location and orientation) with respect to an anechoic chamber housing the measurement antenna array and the device under test.

Thus, no positioning means for adapting a position of the measurement antenna array are necessary.

In a further embodiment of the present invention, the at least one measurement parameter is corrected for a radiation characteristic of the selected measurement antenna subset. In other words, receiver characteristics and/or transmitter characteristics of the selected measurement antenna subset are taken into account for determining the at least one measurement parameter. This way, the precision or rather accuracy of the at least one determined measurement parameter is enhanced.

The radiation characteristic of the selected measurement antenna subset may be stored in a (non-transitory) memory, e.g. during calibration of the measurement antenna array. The radiation characteristic may be loaded from the memory into the processing circuit for determining the at least one measurement parameter.

For example, the radiation characteristic may be an angular distribution of the receiver characteristics and/or an angular distribution of the transmitter characteristics of the selected measurement antenna subset.

A far-field extrapolation of the at least one measurement signal may be performed in order to determine the at least one measurement parameter. Thus, the at least one measurement parameter is associated with far-field properties of the device under test or rather of the at least one antenna to be tested. The far-field properties are determined based on the near-field measurements conducted by means of the selected measurement antenna subset.

Therein, any suitable technique may be used for the far-field extrapolation. For example, equivalent electric and/or magnetic currents may be determined, and the far-field properties of the device under test, i.e. the at least one measurement parameter, may be calculated based on the determined equivalent electric and/or magnetic currents.

Another aspect of the present invention provides that the measurement signal is divided by the reference signal in frequency domain in order to obtain the at least one measurement parameter. In other words, the measurement signal is normalized by dividing the measurement signal by the reference signal, such that comparable measurement results, namely the at least one measurement parameter, are obtained.

In an embodiment of the present invention, the device under test is a mobile network base station. For example, the device under test may support different frequency bands, i.e. the device under test may have different antennas to be tested that are associated with different frequency bands.

Particularly, the device under test may be a 5G base station.

However, it is to be understood that the device under test may be any other electronic device that is configured for wireless communication, e.g. via WLAN, mobile network(s) such as 4G or 5G, Bluetooth, etc.

According to another aspect of the present invention, the device under test has at least two different operational modes being associated with different frequency bands. The measurement method comprises the steps of:
g) generating, in a first operational mode of the device under test being associated with a first frequency band, a quiet zone by means of the measurement antenna array, wherein the device under test is at least partially located in the quiet zone;
h) receiving, by means of the measurement antenna array, electromagnetic waves generated by the at least one antenna to be tested, thereby obtaining a first measurement signal that is forwarded to a processing circuit;
i) determining, by means of the processing circuit, at least one first measurement parameter associated with the at least one antenna to be tested based on the first measurement signal; and
j) performing, in a second operational mode of the device under test being associated with a second frequency band, steps c) to f), particularly of the measurement method described above;

Therein, a second measurement signal is obtained and forwarded to the processing circuit in step d), and at least one second measurement parameter associated with the at least one antenna to be tested is determined based on the second measurement signal and based on the reference signal in step f).

Accordingly, the measurement antenna array has two operational modes that are associated with the different operational modes of the device under test.

In a first operational mode of the device under test and of the measurement antenna array, the complete measurement antenna array is configured to generate a quiet zone, i.e. a region having predefined electromagnetic properties, thereby simulating far-field conditions in a region associated with the device under test.

As long as the device under test or rather the at least one antenna to be tested is smaller than the quiet zone generated by the measurement antenna array, direct OTA measurements with simulated far-field conditions are performed by means of the measurement antenna array, i.e. direct OTA measurements are performed for the first frequency band of the device under test.

However, if the device under test or rather the at least one antenna to be tested that is associated with the second frequency band is larger than the quiet zone that is obtainable by means of the measurement antenna array, near-field measurements are performed by means of the selected measurement antenna subset in a second operational mode of the measurement antenna array and of the device under test.

In the second operational mode, the selected measurement antenna subset serves as a measurement probe for conducting the near-field measurements, as already described in more detail above. The other aspects and properties of the measurement method described above likewise apply.

According to an aspect of the present invention, a central frequency of the first frequency band is larger than a central frequency of the second frequency band. Typically, lower frequency bands require antennas having a larger size. Accordingly, one or several antennas of the device under test that are associated with the first frequency band may be smaller than one or several antennas of the device under test that are associated with the second frequency band. Thus, the one or several antennas of the device under test that are associated with the first frequency band may fit into the quiet zone generated by the measurement antenna array, while the one or several antennas of the device under test that are associated with the second frequency band may be larger than the quiet zone and thus have to be tested by means of the near-field measurement techniques described above.

According to the invention, the problem further is solved by a measurement system for performing over-the-air (OTA) measurements on a device under test. The measurement system comprises a measurement antenna array, wherein the measurement antenna array comprises a plurality of measurement antennas having an adjustable signal weight to a measurement signal processed by the measurement antenna array, respectively. The measurement system further comprises a control circuit, the control circuit being configured to select a measurement antenna subset, wherein the measurement antenna subset comprises at least one of the plurality of measurement antennas. The measurement system further comprises a reference signal source, wherein the reference signal source is configured to generate a reference signal. The measurement system further comprises a processing circuit, wherein the processing circuit is configured to receive a measurement signal generated by the measurement antenna array and the reference signal. The measurement system is configured to perform steps c) to f) of the measurement method described above, particularly wherein the measurement system is configured to (also) perform steps g) to j) of the measurement method described above.

In fact, the measurement system may be configured to perform the measurement method according to any one of the aspects described above.

Regarding the advantages and further properties of the measurement system, reference is made to the explanations given above with respect to the measurement method, which also hold for the measurement system and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a measurement system according to a first variant of the present invention;
- Figure 2 schematically shows a measurement system according to a second variant of the present invention;
- Figure 3 schematically shows a measurement area of the measurement system of Figure 1 or 2;
- Figure 4 shows a flow chart of a measurement method according to the present invention;
- Figure 5 shows a flow chart of a further measurement method according to the present invention; and
- Figure 6 schematically shows a measurement antenna array of the measurement system of Figure 1 or Figure 2.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

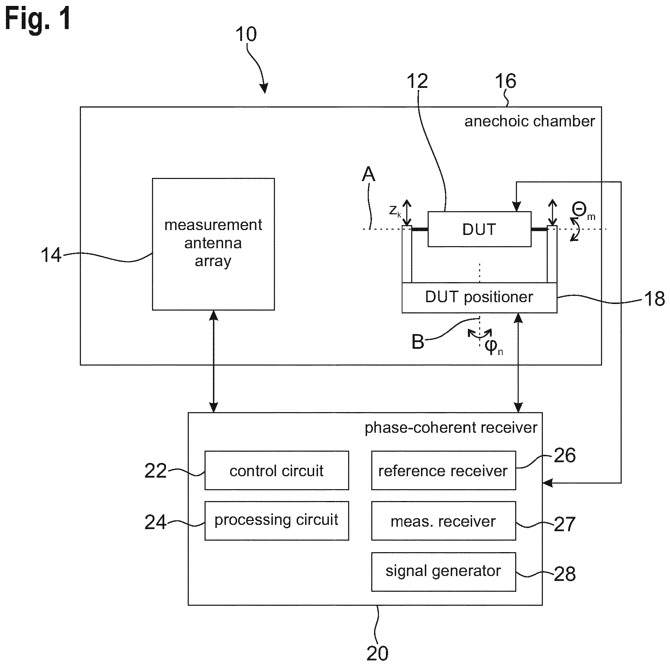

Figure 1 schematically shows a measurement system 10 for performing over-the-air (OTA) measurements on a device under test (DUT) 12.

In general, the device under test 12 may be any electronic device that is configured for wireless communication.

For example, the device under test 12 may be a mobile phone or a base station for mobile communication, particularly a 5G base station.

The measurement system 10 comprises a measurement antenna array 14 that is arranged inside of an anechoic chamber 16, namely in a near-field region of the device under test 12.

More precisely, the measurement antenna array 14 is arranged in a region associated with the radiating near-field of the device under test 12.

In general, the measurement antenna array 14 comprises a plurality of measurement antennas that establish a plane wave converter, which may also be called a plane wave receiver, a plane wave synthesizer, or a phased antenna array.

Accordingly, the measurement antennas have an adjustable signal weight to a measurement signal processed by the measurement antenna array 14, respectively.

For example, the measurement antenna array comprises between 50 and 250 measurement antennas, particularly between 100 and 200 measurement antennas, e.g. 156 measurement antennas.

The individual measurement antennas may be single polarized or dual polarized.

For example, the measurement antennas may be established as a (wideband) Vivaldi antenna or as a dual (wideband) Vivaldi antenna, respectively.

The measurement system 10 further comprises a DUT positioner 18 that is arranged inside of the anechoic chamber 16.

In general the DUT positioner 18 is configured to hold the device under test 12 in a predefined position, and to adapt the position of the device under test 12.

In other words, a position of the device under test 12 is adaptable by means of the DUT positioner 18.

In the exemplary embodiment shown in Figure 1, the DUT positioner 18 is configured to rotate the device under test 12 around a roll axis A, wherein the angle of rotation around the roll axis A is Θ*ₘ*.

Further, the DUT positioner 18 is configured to rotate the device under test 12 around an azimuth axis B, wherein the angle of rotation around the azimuth axis B is φ*ₙ*.

Additionally, the DUT positioner 18 is configured to adapt a height zₖ of the device under test 12.

It is to be understood that the DUT positioner 18 shown in Figure 1 is understood to be exemplary. In fact, any other suitable DUT positioner may be used, i.e. any suitable combination of linear positioner and/or rotational positioner may be used.

The measurement system 10 further comprises a phase-coherent receiver 20.

The phase-coherent receiver 20 may be established as a vector network analyzer or as any other suitable measurement instrument.

The phase-coherent receiver 20 comprises a control circuit 22, a processing circuit 24, a reference receiver 26, a measurement receiver 27, and a signal generator 28.

The functionality of the phase-coherent receiver 20 and of its components will be described in more detail below.

It is noted that while the control circuit 22 and the signal generator 28 are illustrated as being integrated into the phase-coherent receiver 20, it is also conceivable that one or more of these components may be established separately from the phase-coherent receiver 20, e.g. as a dedicated electronic device.

The measurement system 10 described above is particularly suitable for devices under test 12 having an accessible RF port, i.e. devices under test having an antenna that can be fed with an external RF signal, particularly by means of the signal generator 28.

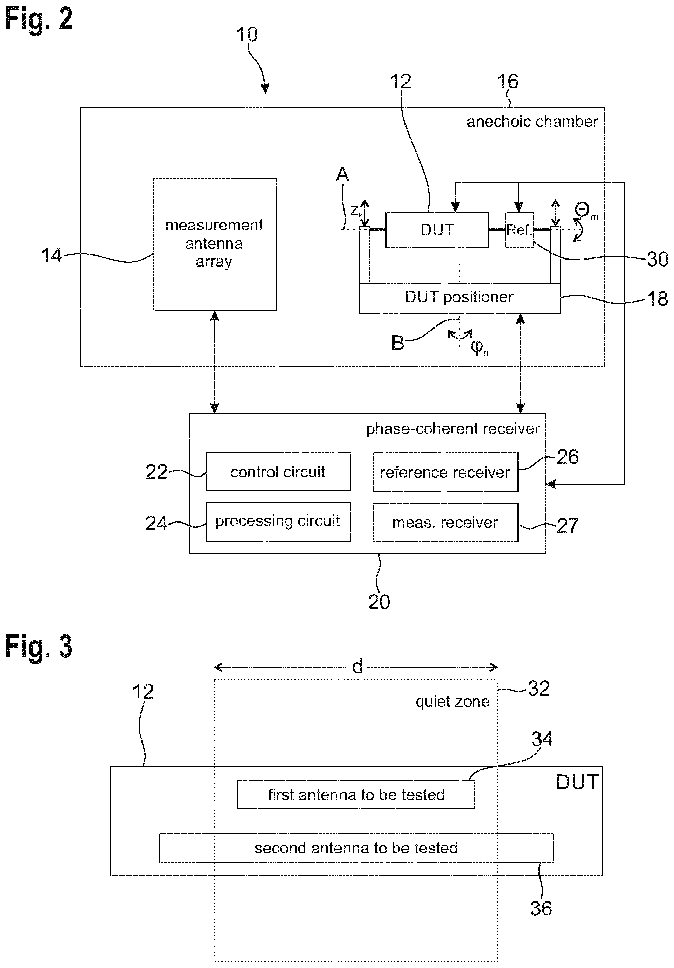

Figure 2 shows a second exemplary embodiment of the measurement system 10, wherein only the differences compared to the first embodiment described above are explained in the following.

The measurement system 10 comprises a reference antenna 30 that is mounted on the DUT positioner 18 at a predefined immutable relative position to the device under test 12.

In other words, if the position of the device under test 12 is adapted by means of the DUT positioner 18, the relative distance and relative orientation between the device under test 12 and the reference antenna 30 remains constant, i.e. does not change.

It is noted that while the phase-coherent receiver 20 is shown without the signal generator 28, it is to be understood that the phase-coherent receiver 20 may still comprise the signal generator 28.

The measurement system 10 of Figure 2 is particularly suitable for devices under test 12 having no accessible RF port, i.e. devices under test having a highly integrated antenna or highly integrated antennas that cannot be fed with an external RF signal.

The measurement system 10 describe above is configured to perform two different types of measurements depending on a size of the device under test 12 or rather depending on a size of antennas to be tested.

As is illustrated in Figure 3, the measurement antenna array 14 is configured to generate a quiet zone 32 having a predefined width d.

It is noted that while the quiet zone 32 is illustrated with a square base area in Figure 3, the quiet zone 32 may in fact have any other shape, depending on the geometry and signal weights of the measurement antennas of measurement antenna array 14.

In fact, the quiet zone 32 may be three-dimensional. For example, the quiet zone 32 may be a three-dimensional sphere.

In the exemplary embodiment shown in Figure 3, the device under test 12 comprises a first antenna 34 to be tested and a second antenna 36 to be tested.

Of course, the device under test 12 may have any other number of antennas.

For example, the device under test 12 may support different frequency bands by means of the first antenna 34 and the second antenna 36.

In other words, the device under test 12 may have a first operational mode that is associated with a first frequency band, wherein the first antenna 34 is active in the first operational mode.

Further, the device under test 12 may have a second operational mode that is associated with a second frequency band, wherein the second antenna 36 is active in the second operational mode.

A central frequency of the first frequency band may larger than a central frequency of the second frequency band.

Accordingly, the size of the second antenna 36 is larger than the size of the first antenna 34.

As is illustrated in Figure 3, the size of the second antenna 36 to be tested is larger than the quiet zone 32 generated by the measurement antenna array 14.

Nevertheless, both antennas 34, 36 can be tested by means of the measurement system 10.

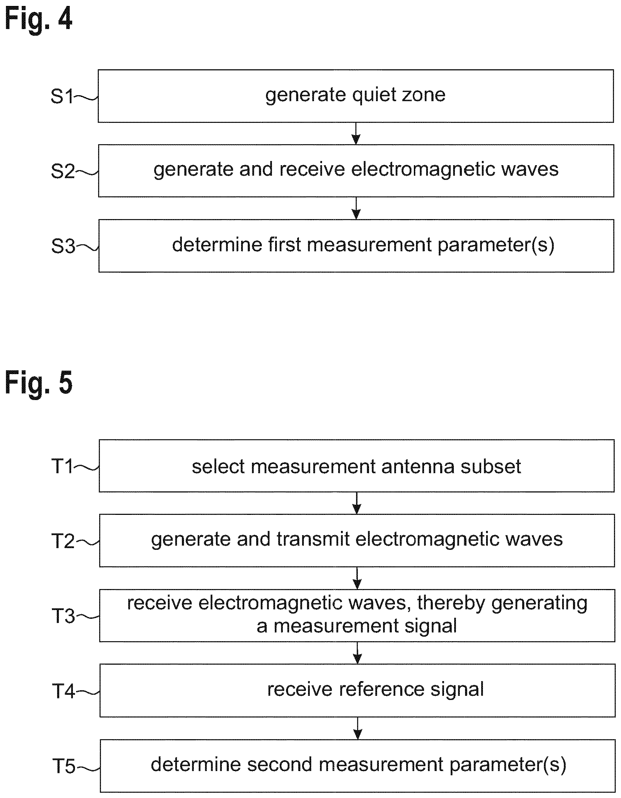

More precisely, the measurement system 10 is configured to perform a measurement method of performing OTA measurements on the device under test 12, which is explained in the following with reference to Figure 4.

In the first operational mode of the device under test 12 being associated with the first frequency band, the quiet zone 32 is generated by means of the measurement antenna array 14 (step S1).

As is illustrated in Figure 3, the first antenna 34 is completely located within the quiet zone 32, i.e. the measurement antenna array 14 acts as a plane wave receiver for the first antenna 34.

In other words, far-field conditions are simulated for the first antenna 34 by means of the measurement antenna array 14, namely by appropriately adjusting signal weights of the individual measurement antennas of the measurement antenna array 14.

Electromagnetic waves are generated by means of the first antenna 34 to be tested, wherein the generated electromagnetic waves are received by means of the measurement antenna array 14, thereby generating a first measurement signal (step S2).

The first measurement signal is forwarded to the processing circuit 24.

More precisely, the first measurement signal may be received by means of the measurement receiver 27 and may be forwarded to the processing circuit 24.

At least one first measurement parameter associated with the first antenna 34 to be tested is determined based on the first measurement signal by means of the processing circuit 24 (step S3).

Several measurements may be performed for different positions of the device under test 12, i.e. the at least one first measurement parameter may be determined for different positions (φ*ₙ*, Θ*ₘ*, *zₖ*) of the device under test 12, such that the device under test 12 is fully characterized.

However, the measurement antenna array 14 may remain stationary, i.e. the position of the measurement antenna array 14 with respect to the anechoic chamber 16 is not adapted.

Particularly, if the measurement antennas of the measurement antenna array 14 are single-polarized antennas, the device under test 12 may be rotated by 90°, such that the corresponding orthogonal polarization can be measured.

For example, the first measurement parameter may be a (total) radiated power, an angular distribution of the radiated power, an error vector magnitude (EVM), an angular distribution of the EVM, an adjacent channel leakage power ratio, an angular distribution of the adjacent channel leakage power ratio, or any other measurement parameter of interest that is characterizing the performance of the device under test.

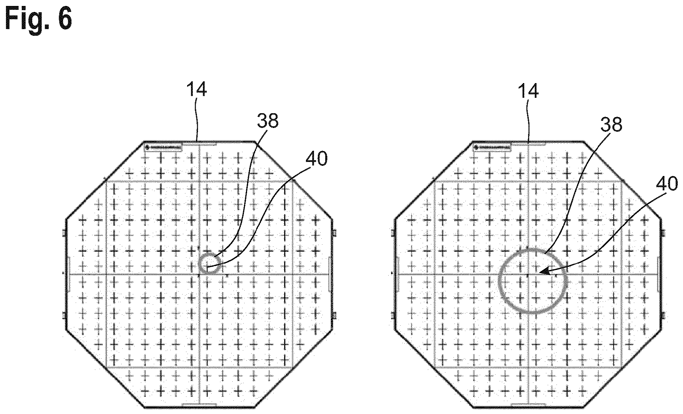

In the second operational mode of the device under test 12 being associated with the second frequency band, the measurement system 10 is configured to perform a measurement method of performing OTA measurements on the device under test 12, which is explained in the following with reference to Figures 5 and 6.

A measurement antenna subset 38 is selected by means of the control circuit 22, wherein the measurement antenna subset 38 comprises at least one of the plurality of measurement antennas (step T1).

As is illustrated in Figure 6, the measurement antenna subset 38 may comprise a single measurement antenna 40 (left hand side of Figure 6) or several measurement antennas 40 (right hand side of Figure 6).

If the selected measurement antenna subset 38 comprises a plurality of measurement antennas 40, the signal weights of the plurality of measurement antennas 40 may be optimized such that a desired receiver and/or transmitter characteristic of the measurement antenna subset 38 is obtained for performing near-field measurements.

Electromagnetic waves are generated and transmitted by the device under test 12, particularly by means of the second antenna 36 to be tested (step T2).

If the second antenna 36 to be tested has an accessible RF port, the signal generator 28 may generate an RF signal that is forwarded to the second antenna 36, and the second antenna 36 may generate the electromagnetic waves based on the RF signal received from the signal generator 28.

If the second antenna 36 does not have an accessible RF port, the device under test 12 may control the second antenna 36 to generate the electromagnetic waves.

Alternatively or additionally, the control circuit 22 may control the device under test 12 such that the electromagnetic waves are generated by means of the second antenna 36.

The generated electromagnetic waves are received by means of the selected measurement antenna subset 38, thereby generating a second measurement signal (step T3).

The second measurement signal is forwarded to the processing circuit 24.

More precisely, the second measurement signal may be received by means of the measurement receiver 27 and may be forwarded to the processing circuit 24.

A reference signal is received and forwarded to the processing circuit 24 (step T4).

More precisely, the second measurement signal may be received by means of the reference receiver 26 and may be forwarded to the processing circuit 24.

If the second antenna 36 to be tested has an accessible RF port, the reference signal may be received from the signal generator 28 that is integrated into the phase-coherent receiver 20.

In other words, the signal generator 28 may have an integrated reference signal source. However, it is also conceivable that the reference signal source is integrated into the phase-coherent receiver 20, but may be established separately from the signal generator 28.

If the second antenna 36 does not have an accessible RF port, the reference signal may be received from the reference antenna 30, which measures the electromagnetic waves generated by the device under test 12, thereby generating the reference signal.

At least one second measurement parameter associated with second antenna 36 to be tested is determined by means of the processing circuit 24 based on the second measurement signal and based on the reference signal (step T5).

The second measurement signal may be divided by the reference signal in frequency domain in order to obtain the at least one second measurement parameter. In other words, the second measurement signal is normalized by dividing the second measurement signal by the reference signal, such that comparable measurement results, namely the at least one second measurement parameter, are obtained.

In other words, the at least one second measurement parameter may be or may be determined based on the ratio *V*(φ*ₙ*, Θ*ₘ*, *zₖ*) = *aₘₑₐₛ*(φ*ₙ*, Θ*ₘ*, *zₖ*)/ *a_{ref}* (φ*ₙ*, Θ*ₘ*, *zₖ*), wherein *aₘₑₐₛ* denotes the second measurement signal, and wherein *a_{ref}* denotes the reference signal.

The second measurement signal and the reference signal may corresponds to a measured voltage, respectively.

Alternatively or additionally, a far-field extrapolation of the second measurement signal may be performed in order to determine the at least one second measurement parameter. Thus, the at least one second measurement parameter is associated with far-field properties of the device under test 12 or rather of the second antenna 36 to be tested.

Therein, any suitable technique may be used for the far-field extrapolation. For example, equivalent electric and/or magnetic currents may be determined, and the far-field properties of the second antenna 36 may be calculated based on the determined equivalent electric and/or magnetic currents.

Several measurements may be performed for different positions of the device under test 12, i.e. the at least one second measurement parameter may be determined for different positions (φ*ₙ*, Θ*ₘ*, *zₖ*) of the device under test 12.

Alternatively or additionally, several second measurement signals may be obtained consecutively by means of different selected measurement antenna subsets 38, wherein at least one second measurement parameter is determined based on the second measurement signals, respectively.

In other words, several measurements are performed by means of different measurement antenna subsets 38, namely by electronically switching between the different measurement antenna subsets 38. This technique may also be called "electronically switched near-field scanning".

In fact, several second measurement signals may be obtained consecutively at different positions of the device under test 12 and/or by means of different selected measurement antenna subsets 38, i.e. the two aspects described above can be combined arbitrarily.

Thus, a predefined sampling grid is obtained on a surface around the device under test 12, particularly a closed sampling grid on a surface surrounding the device under test 12.

Therein, the measurement antenna subset 38 may be selected based on a current position of the device under test 12. Accordingly, a suitable measurement antenna subset 38 or several different suitable measurement antenna subsets 38 may be selected for each position of the device under test 12, such that the amount of time necessary for obtaining the predefined sampling grid is reduced.

The measurement antenna array 14 may remain stationary, i.e. the position of the measurement antenna array 14 with respect to the anechoic chamber 16 is not adapted between measurements.

The second measurement parameter may be a (total) radiated power, an angular distribution of the radiated power, an error vector magnitude (EVM), an angular distribution of the EVM, an adjacent channel leakage power ratio, an angular distribution of the adjacent channel leakage power ratio, or any other measurement parameter of interest that is characterizing the performance of the device under test.

Optionally, the at least one second measurement parameter is corrected for a radiation characteristic of the selected measurement antenna subset(s) 38. In other words, a probe compensation may be performed.

In other words, receiver characteristics and/or transmitter characteristics of the selected measurement antenna subset(s) 38 are taken into account for determining the at least one measurement parameter.

This way, the precision or rather accuracy of the at least one determined second measurement parameter is enhanced.

The radiation characteristic of the selected measurement antenna subset(s) 38 may be stored in a (non-transitory) memory, particularly in a memory of the phase-coherent receiver 20, e.g. during calibration of the measurement antenna array 14. The radiation characteristic may be loaded from the memory into the processing circuit 24 for determining the at least one second measurement parameter.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A measurement method of performing over-the-air (OTA) measurements on a device under test (12), the measurement method comprising the steps of
a) providing a measurement antenna array (14), wherein the measurement antenna array (14) comprises a plurality of measurement antennas (40) having an adjustable signal weight to a measurement signal processed by the measurement antenna array (14), respectively;
b) providing a device under test (12), wherein the device under test (12) comprises at least one antenna (34, 36) to be tested, wherein the device under test (12) is placed with respect to the measurement antenna array (14) such that the measurement antenna array (14) is located in a near-field region of the device under test (12);
c) selecting, by means of a control circuit (22), a measurement antenna subset (38), wherein the measurement antenna subset (38) comprises at least one of the plurality of measurement antennas (40);
d) receiving, by means of the selected measurement antenna subset (38), electromagnetic waves generated by the at least one antenna (34. 36) to be tested, thereby obtaining the measurement signal that is forwarded to a processing circuit (24); the method is **characterised by**
e) receiving, by means of the processing circuit (24), a reference signal which provides a phase reference from a reference signal source; and
f) determining, by means of the processing circuit (24), at least one measurement parameter associated with the at least one antenna (34, 36) to be tested based on the measurement signal and based on the reference signal.

2. The measurement method of claim 1, wherein the measurement antenna array (14) is a plane wave converter.

3. The measurement method according to any one of the preceding claims, wherein the processing circuit (24) is integrated into a phase-coherent receiver (20), wherein the phase-coherent receiver (20) is connected to the measurement antenna array (14).

4. The measurement method of claim 3, wherein the reference signal source is integrated into the phase-coherent receiver (20), wherein the phase-coherent receiver (20) is connected to the device under test (12).

5. The measurement method of claim 3 or 4, wherein the phase-coherent receiver (20) is a vector signal analyzer.

6. The measurement method of claim 4 or 5, wherein the phase-coherent receiver (20) comprises a signal generator (28), wherein the signal generator (28) is connected with the device under test (12), and wherein the signal generator (28) controls the at least one antenna (34, 36) to be tested to generate the electromagnetic waves.

7. The measurement method according to any one of the preceding claims, wherein the reference signal source is a reference antenna (30), wherein the reference antenna (30) receives electromagnetic waves generated by the at least one antenna (34, 36) to be tested, thereby generating the reference signal.

8. The measurement method of claim 7, wherein the reference antenna (30) is mounted at a predefined immutable relative position to the device under test (12).

9. The measurement method according to any one of the preceding claims, wherein the device under test (12) is mounted on a DUT positioner (18), wherein a position of the device under test (12) is adaptable by means of the DUT positioner (18).

10. The measurement method of claim 9, wherein several measurement signals are obtained consecutively at different positions of the device under test (12), and wherein at least one respective measurement parameter is determined based on the measurement signals, respectively.

11. The measurement method according to any one of the preceding claims, wherein several measurement signals are obtained consecutively by means of different selected subsets (38) of measurement antennas (40), and wherein at least one respective measurement parameter is determined based on the measurement signals, respectively.

12. The measurement method of claim 11, wherein the measurement antenna subset (38) is selected based on a current position of the device under test (12).

13. The measurement method according to any one of the preceding claims, wherein the measurement antenna array (14) remains stationary.

14. The measurement method according to any one of the preceding claims, wherein the at least one measurement parameter is corrected for a radiation characteristic of the selected measurement antenna subset (38).

15. The measurement method according to any one of the preceding claims, wherein a far-field extrapolation of the at least one measurement signal is performed in order to determine the at least one measurement parameter.

16. The measurement method according to any one of the preceding claims, wherein the measurement signal is divided by the reference signal in frequency domain in order to obtain the at least one measurement parameter.

17. The measurement method according to any one of the preceding claims, wherein the device under test (12) has at least two different operational modes being associated with different frequency bands, wherein the measurement method comprises the steps of
g) generating, in a first operational mode of the device under test (12) being associated with a first frequency band, a quiet zone (32) by means of the measurement antenna array (14), wherein the device under test (12) is at least partially located in the quiet zone (32);
h) receiving, by means of the measurement antenna array (14), electromagnetic waves generated by the at least one antenna (34, 36) to be tested, thereby obtaining a first measurement signal that is forwarded to a processing circuit (24);
i) determining, by means of the processing circuit (24), at least one first measurement parameter associated with the at least one antenna (34, 36) to be tested based on the first measurement signal; and
j) performing, in a second operational mode of the device under test (12) being associated with a second frequency band, steps c) to f);
wherein a second measurement signal is obtained and forwarded to the processing circuit (24) in step d), and wherein at least one second measurement parameter associated with the at least one antenna (34, 36) to be tested is determined based on the second measurement signal and based on the reference signal in step f).

18. The measurement method of claim 17, wherein a central frequency of the first frequency band is larger than a central frequency of the second frequency band.

19. A measurement system for performing over-the-air (OTA) measurements on a device under test (12), the measurement system comprising
a measurement antenna array (14), wherein the measurement antenna array (14) comprises a plurality of measurement antennas (40) having an adjustable signal weight to a measurement signal processed by the measurement antenna array (14), respectively,
a control circuit (22), the control circuit (22) being configured to select a measurement antenna subset (38), wherein the measurement antenna subset (38) comprises at least one of the plurality of measurement antennas (40),
the measurement system is **characterised by**
a reference signal source, wherein the reference signal source is configured to generate a reference signal which provides a phase reference, and
a processing circuit (24), wherein the processing circuit (24) is configured to receive a measurement signal generated by the measurement antenna array (14) and the reference signal,
wherein the measurement system (10) is configured to perform steps c) to f) of any one of claims 1 to 17, particularly wherein the measurement system (10) is configured to perform steps g) to j) of claim 17 or 18.

## Patentansprüche

1. Messverfahren zum Durchführen von Over-the-Air-Messungen (OTA-Messungen) auf einem Prüfling (12), das Messverfahren umfassend die Schritte
a) Bereitstellen einer Messantennenanordnung (14), wobei die Messantennenanordnung (14) eine Vielzahl von Messantennen (40) umfasst, die jeweils ein einstellbares Signalgewicht zu einem von der Messantennenanordnung (14) verarbeiteten Messsignal aufweisen;
b) Bereitstellen eines Prüflings (12), wobei der Prüfling (12) mindestens eine zu testende Antenne (34, 36) umfasst, wobei der Prüfling (12) in Bezug auf die Messantennenanordnung (14) derart platziert wird, dass sich die Messantennenanordnung (14) in einem Nahfeldbereich des Prüflings (12) befindet;
c) Auswählen, mittels einer Steuerschaltung (22), einer Messantennen-Teilmenge (38), wobei die Messantennen-Teilmenge (38) mindestens eine der Vielzahl von Messantennen (40) umfasst;
d) Empfangen, mittels der ausgewählten Messantennen-Teilmenge (38), von elektromagnetischen Wellen, die von der mindestens einen zu testenden Antenne (34, 36) erzeugt werden, wodurch das Messsignal erhalten wird, das an eine Verarbeitungsschaltung (24) weitergeleitet wird; wobei das Verfahren **gekennzeichnet ist durch**
e) Empfangen, mittels der Verarbeitungsschaltung (24), eines Referenzsignals, welches eine Phasenreferenz von einer Referenzsignalquelle bereitstellt; und
f) Bestimmen, mittels der Verarbeitungsschaltung (24), mindestens eines Messparameters, der mit der mindestens einen zu testenden Antenne (34, 36) assoziiert ist, basierend auf dem Messsignal und basierend auf dem Referenzsignal.

2. Messverfahren nach Anspruch 1, wobei die Messantennenanordnung (14) ein Ebenenwellenwandler ist.

3. Messverfahren nach einem der vorstehenden Ansprüche, wobei die Verarbeitungsschaltung (24) in einen phasenkohärenten Empfänger (20) integriert ist, wobei der phasenkohärente Empfänger (20) mit der Messantennenanordnung (14) verbunden ist.

4. Messverfahren nach Anspruch 3, wobei die Referenzsignalquelle in den phasenkohärenten Empfänger (20) integriert ist, wobei der phasenkohärente Empfänger (20) mit dem Prüfling (12) verbunden ist.

5. Messverfahren nach Anspruch 3 oder 4, wobei der phasenkohärente Empfänger (20) ein Vektorsignal-Analysator ist.

6. Messverfahren nach Anspruch 4 oder 5, wobei der phasenkohärente Empfänger (20) einen Signalgenerator (28) umfasst, wobei der Signalgenerator (28) mit dem Prüfling (12) verbunden ist, und wobei der Signalgenerator (28) die mindestens eine zu testende Antenne (34, 36) steuert, um die elektromagnetischen Wellen zu erzeugen.

7. Messverfahren nach einem der vorstehenden Ansprüche, wobei die Referenzsignalquelle eine Referenzantenne (30) ist, wobei die Referenzantenne (30) elektromagnetische Wellen empfängt, die von der mindestens einen zu testenden Antenne (34, 36) erzeugt werden, wodurch das Referenzsignal erzeugt wird.

8. Messverfahren nach Anspruch 7, wobei die Referenzantenne (30) an einer vorgegebenen unveränderlichen relativen Position zu dem Prüfling (12) angebracht ist.

9. Messverfahren nach einem der vorstehenden Ansprüche, wobei der Prüfling (12) auf einem DUT-Positionierer (18) montiert ist, wobei eine Position des Prüflings (12) mittels des DUT-Positionierers (18) anpassbar ist.

10. Messverfahren nach Anspruch 9, wobei mehrere Messsignale nacheinander an verschiedenen Positionen des Prüflings (12) erhalten werden, und wobei mindestens ein jeweiliger Messparameter basierend auf den Messsignalen jeweils bestimmt wird.

11. Messverfahren nach einem der vorstehenden Ansprüche, wobei mehrere Messsignale nacheinander mittels verschiedener ausgewählter Teilmengen (38) von Messantennen (40) erhalten werden, und wobei mindestens ein jeweiliger Messparameter basierend auf den Messsignalen jeweils bestimmt wird.

12. Messverfahren nach Anspruch 11, wobei die Messantennen-Teilmenge (38) basierend auf einer aktuellen Position des Prüflings (12) ausgewählt wird.

13. Messverfahren nach einem der vorstehenden Ansprüche, wobei die Messantennenanordnung (14) stationär bleibt.

14. Messverfahren nach einem der vorstehenden Ansprüche, wobei der mindestens eine Messparameter in Bezug auf eine Strahlungscharakteristik der ausgewählten Messantennen-Teilmenge (38) korrigiert wird.

15. Messverfahren nach einem der vorstehenden Ansprüche, wobei eine Fernfeld-Extrapolation des mindestens einen Messsignals durchgeführt wird, um den mindestens einen Messparameter zu bestimmen.

16. Messverfahren nach einem der vorstehenden Ansprüche, wobei das Messsignal durch das Referenzsignal im Frequenzbereich geteilt wird, um den mindestens einen Messparameter zu erhalten.

17. Messverfahren nach einem der vorstehenden Ansprüche, wobei der Prüfling (12) mindestens zwei verschiedene Betriebsmodi aufweist, die verschiedenen Frequenzbändern zugeordnet sind, das Messverfahren umfassend die Schritte
g) Erzeugen, in einem ersten Betriebsmodus des Prüflings (12), der einem ersten Frequenzband zugeordnet ist, einer ruhigen Zone (32) mittels der Messantennenanordnung (14), wobei der Prüfling (12) mindestens teilweise in der ruhigen Zone (32) angeordnet ist;
h) Empfangen, mittels der Messantennenanordnung (14), von elektromagnetischen Wellen, die von der mindestens einen zu testenden Antenne (34, 36) erzeugt werden, wodurch ein erstes Messsignal erhalten wird, das an eine Verarbeitungsschaltung (24) weitergeleitet wird;
i) Bestimmen, mittels der Verarbeitungsschaltung (24), mindestens eines ersten Messparameters, der der mindestens einen zu testenden Antenne (34, 36) zugeordnet ist, basierend auf dem ersten Messsignal; und
j) Durchführen, in einem zweiten Betriebsmodus des Prüflings (12), der einem zweiten Frequenzband zugeordnet ist, der Schritte c) bis f);
wobei ein zweites Messsignal erhalten und an die Verarbeitungsschaltung (24) in Schritt d) weitergeleitet wird, und wobei mindestens ein zweiter Messparameter, der der mindestens einen zu testenden Antenne (34, 36) zugeordnet ist, basierend auf dem zweiten Messsignal und basierend auf dem Referenzsignal in Schritt f) bestimmt wird.

18. Messverfahren nach Anspruch 17, wobei eine Mittelfrequenz des ersten Frequenzbandes höher ist als eine Mittelfrequenz des zweiten Frequenzbandes.

19. Messsystem zum Durchführen von Over-the-Air-Messungen (OTA-Messungen) an einem Prüfling (12), das Messsystem umfassend
eine Messantennenanordnung (14), wobei die Messantennenanordnung (14) eine Vielzahl von Messantennen (40) umfasst, die jeweils ein einstellbares Signalgewicht zu einem von der Messantennenanordnung (14) verarbeiteten Messsignal aufweisen;
eine Steuerschaltung (22), wobei die Steuerschaltung (22) konfiguriert ist, um eine Messantennen-Teilmenge (38) auszuwählen, wobei die Messantennen-Teilmenge (38) mindestens eine der Vielzahl von Messantennen (40) umfasst, wobei das Messsystem **gekennzeichnet ist durch**
eine Referenzsignalquelle, wobei die Referenzsignalquelle konfiguriert ist, um ein Referenzsignal zu erzeugen, welches eine Phasenreferenz bereitstellt, und
eine Verarbeitungsschaltung (24), wobei die Verarbeitungsschaltung (24) konfiguriert ist, um ein von der Messantennenanordnung (14) erzeugtes Messsignal und das Referenzsignal zu empfangen,
wobei das Messsystem (10) konfiguriert ist, um die Schritte c) bis f) eines der Ansprüche 1 bis 17 durchzuführen, insbesondere wobei das Messsystem (10) konfiguriert ist, um die Schritte g) bis j) des Anspruchs 17 oder 18 durchzuführen.

## Revendications

1. Procédé de mesure permettant d'effectuer des mesures par voie hertzienne (OTA) sur un dispositif soumis à un test (12), le procédé de mesure comprenant les étapes consistant à
a) fournir un réseau d'antennes de mesure (14), dans lequel le réseau d'antennes de mesure (14) comprend une pluralité d'antennes de mesure (40) ayant un poids de signal réglable par rapport à un signal de mesure traité par le réseau d'antennes de mesure (14), respectivement ;
b) fournir un dispositif soumis à un test (12), dans lequel le dispositif soumis à un test (12) comprend au moins une antenne (34, 36) à tester, dans lequel le dispositif soumis à un test (12) est placé par rapport au réseau d'antennes de mesure (14) de telle sorte que le réseau d'antennes de mesure (14) est situé dans une région en champ proche du dispositif soumis à un test (12) ;
c) choisir, au moyen d'un circuit de commande (22), un sous-ensemble d'antennes de mesure (38), dans lequel le sous-ensemble d'antennes de mesure (38) comprend au moins l'une de la pluralité d'antennes de mesure (40) ;
d) recevoir, au moyen du sous-ensemble d'antennes de mesure (38) choisi, des ondes électromagnétiques générées par l'au moins une antenne (34, 36) à tester, ce qui permet d'obtenir le signal de mesure qui est transmis à un circuit de traitement (24) ; le procédé est **caractérisé par**
e) recevoir, au moyen du circuit de traitement (24), un signal de référence qui fournit une référence de phase d'une source de signal de référence ; et
f) déterminer, au moyen du circuit de traitement (24), au moins un paramètre de mesure associé à l'au moins une antenne (34, 36) à tester en fonction du signal de mesure et en fonction du signal de référence.

2. Procédé de mesure selon la revendication 1, dans lequel le réseau d'antennes de mesure (14) est un convertisseur d'ondes planes.

3. Procédé de mesure selon l'une quelconque des revendications précédentes, dans lequel le circuit de traitement (24) est intégré dans un récepteur à cohérence de phase (20), dans lequel le récepteur à cohérence de phase (20) est connecté au réseau d'antennes de mesure (14).

4. Procédé de mesure selon la revendication 3, dans lequel la source de signal de référence est intégrée dans le récepteur à cohérence de phase (20), dans lequel le récepteur à cohérence de phase (20) est connecté au dispositif soumis à un test (12).

5. Procédé de mesure selon la revendication 3 ou 4, dans lequel le récepteur à cohérence de phase (20) est un analyseur de signal vectoriel.

6. Procédé de mesure selon la revendication 4 ou 5, dans lequel le récepteur à cohérence de phase (20) comprend un générateur de signal (28), dans lequel le générateur de signal (28) est connecté au dispositif soumis à un test (12), et dans lequel le générateur de signal (28) commande l'au moins une antenne (34, 36) à tester pour générer les ondes électromagnétiques.

7. Procédé de mesure selon l'une quelconque des revendications précédentes, dans lequel la source de signal de référence est une antenne de référence (30), dans lequel l'antenne de référence (30) reçoit des ondes électromagnétiques générées par l'au moins une antenne (34, 36) à tester, ce qui permet de générer le signal de référence.

8. Procédé de mesure selon la revendication 7, dans lequel l'antenne de référence (30) est montée à niveau d'une position relative immuable prédéfinie par rapport au dispositif soumis à un test (12).

9. Procédé de mesure selon l'une quelconque des revendications précédentes, dans lequel le dispositif soumis à un test (12) est monté sur un positionneur de DUT (18), dans lequel une position du dispositif soumis à un test (12) est adaptable au moyen du positionneur de DUT (18).

10. Procédé de mesure selon la revendication 9, dans lequel plusieurs signaux de mesure sont obtenus consécutivement au niveau de différentes positions du dispositif soumis à un test (12), et dans lequel au moins un paramètre de mesure respectif est déterminé en fonction des signaux de mesure, respectivement.

11. Procédé de mesure selon l'une quelconque des revendications précédentes, dans lequel plusieurs signaux de mesure sont obtenus consécutivement au moyen de différents sous-ensembles (38) choisis d'antennes de mesure (40), et dans lequel au moins un paramètre de mesure respectif est déterminé par rapport aux signaux de mesure, respectivement.

12. Procédé de mesure selon la revendication 11, dans lequel le sous-ensemble d'antennes de mesure (38) est choisi en fonction d'une position actuelle du dispositif soumis à un test (12).

13. Procédé de mesure selon l'une quelconque des revendications précédentes, dans lequel le réseau d'antennes de mesure (14) reste stationnaire.

14. Procédé de mesure selon l'une quelconque des revendications précédentes, dans lequel l'au moins un paramètre de mesure est corrigé pour une caractéristique de rayonnement du sous-ensemble d'antennes de mesure (38) choisi.

15. Procédé de mesure selon l'une quelconque des revendications précédentes, dans lequel une extrapolation en champ lointain de l'au moins un signal de mesure est effectuée afin de déterminer l'au moins un paramètre de mesure.

16. Procédé de mesure selon l'une quelconque des revendications précédentes, dans lequel le signal de mesure est divisé par le signal de référence dans un domaine fréquentiel afin d'obtenir l'au moins un paramètre de mesure.

17. Procédé de mesure selon l'une quelconque des revendications précédentes, dans lequel le dispositif soumis à un test (12) a au moins deux modes de fonctionnement différents associés à différentes bandes de fréquences, dans lequel le procédé de mesure comprend les étapes consistant à
g) générer, dans un premier mode de fonctionnement du dispositif soumis à un test (12) associé à une première bande de fréquences, une zone silencieuse (32) au moyen du réseau d'antennes de mesure (14), dans lequel le dispositif soumis à un test (12) est au moins partiellement situé dans la zone silencieuse (32) ;
h) recevoir, au moyen du réseau d'antennes de mesure (14), des ondes électromagnétiques générées par l'au moins une antenne (34, 36) à tester, ce qui permet d'obtenir un premier signal de mesure qui est transmis à un circuit de traitement (24) ;
i) déterminer, au moyen du circuit de traitement (24), au moins un premier paramètre de mesure associé à l'au moins une antenne (34, 36) à tester en fonction du premier signal de mesure ; et
j) effectuer, dans un second mode de fonctionnement du dispositif soumis à un test (12) associé à une seconde bande de fréquences, les étapes c) à f) ;
dans lequel un second signal de mesure est obtenu et transmis au circuit de traitement (24) à l'étape d), et dans lequel au moins un deuxième paramètre de mesure associé à l'au moins une antenne (34, 36) à tester est déterminé en fonction du second signal de mesure et en fonction du signal de référence à l'étape f).

18. Procédé selon la revendication 17, dans lequel une fréquence centrale de la première bande de fréquences est supérieure à une fréquence centrale de la seconde bande de fréquences.

19. Système de mesure permettant d'effectuer des mesures par voie hertzienne (OTA) sur un dispositif soumis à un test (12), le système de mesure comprenant
un réseau d'antennes de mesure (14), dans lequel le réseau d'antennes de mesure (14) comprend une pluralité d'antennes de mesure (40) ayant un poids de signal réglable par rapport à un signal de mesure traité par le réseau d'antennes de mesure (14), respectivement,
un circuit de commande (22), le circuit de commande (22) étant configuré pour choisir un sous-ensemble d'antennes de mesure (38), dans lequel le sous-ensemble d'antennes de mesure (38) comprend au moins l'une de la pluralité d'antennes de mesure (40), le système de mesure est **caractérisé par**
une source de signal de référence, dans lequel la source de signal de référence est configurée pour générer un signal de référence qui fournit une référence de phase, et
un circuit de traitement (24), dans lequel le circuit de traitement (24) est configuré pour recevoir un signal de mesure généré par le réseau d'antennes de mesure (14) et le signal de référence,
dans lequel le système de mesure (10) est configuré pour effectuer les étapes c) à f) selon l'une quelconque des revendications 1 à 17, en particulier dans lequel le système de mesure (10) est configuré pour effectuer les étapes g) à j) selon la revendication 17 ou 18.
